# EUROPEAN PATENT APPLICATION

(11) **EP 4 693 389 A1**
(43) Date of publication of application: **11.02.2026**
(21) Application number: 24780898.3
(22) Date of filing: 29.03.2024
(51) Int. Cl.: H01L 23/13, H05K 3/38

(54) **SUBSTRATE FOR SEMICONDUCTOR DEVICE**

(30) Priority: 31.03.2023 WO PCT/JP2023/013740
(71) Applicant: NGK Insulators, Ltd., Nagoya-shi, Aichi 467-8530 (JP)
(72) Inventor: KAKU, Takeshi, Nagoya-shi, Aichi 467-8530 (JP); MASUDA, Izumi, Nagoya-shi, Aichi 467-8530 (JP); EBIGASE, Takashi, Nagoya-shi, Aichi 467-8530 (JP)
(74) Representative: Mewburn Ellis LLP
(86) International application number: PCT/JP2024/013280
(87) International publication number: WO 2024/204804

(57) **Abstract**

A semiconductor device substrate according to the present invention includes a silicon nitride ceramic substrate having a first surface and a second surface, brazing material layers respectively disposed on the first surface and the second surface, and copper plates respectively disposed on the bonding layers, including a region where hardness decreases along a thickness direction of each copper plate from an interface between a corresponding one of the bonding layers and the copper plate and the interface.

## Description

### Technical Field

The present invention relates to a semiconductor device substrate.

### Background Art

As a semiconductor device substrate used for a power transistor module or the like, a substrate including a copper plate disposed on a surface of a silicon nitride ceramic substrate with a bonding agent interposed between the copper plate and the substrate is known (for example, PTL 1).

### Citation List

### Patent Literature

PTL 1: Japanese Patent Laid-open Publication No. 2022-173209

### Summary of Invention

### Technical Problem

The semiconductor device substrate has a problem of durability in a hot-cold cycle, and there has been a demand for a semiconductor device substrate capable of suppressing peeling of a copper plate even under such an environment. The present invention has been made to solve this problem, and an object of the present invention is to provide a semiconductor device substrate capable of suppressing peeling of a copper plate even under a hot-cold cycle.

### Solution to Problem

Item 1. A semiconductor device substrate including:
a ceramic substrate having a first surface and a second surface;
brazing material layers respectively disposed on the first surface and the second surface; and
copper plates respectively disposed on the bonding layers,
in which each of the copper plates has a thickness of 0.3 mm or more, and
each of the copper plates includes a region where hardness decreases along a thickness direction of the copper plate between a position separated from an interface between a corresponding one of the bonding layers and the copper plate by 100 µm in the thickness direction and the interface.

Item 2. The semiconductor device substrate according to Item 1, in which at least one of the copper plates is patterned.

Item 3. The semiconductor device substrate according to Item 1 or 2, in which each of the copper plate has a nanoindentation hardness at a first position separated from the interface by 10 µm in the thickness direction of 1.2 GPa to 2.3 GPa, and
each of the copper plate has a nanoindentation hardness at a position more separated from the interface than the first position lower than the nanoindentation hardness at the first position.

Item 4. The semiconductor device substrate according to any one of Items 1 to 3, in which
each of the copper plate has a nanoindentation hardness at a second position separated from the interface by 30 µm in the thickness direction of 0.7 GPa to 1.3 GPa, and
each of the copper plate has a nanoindentation hardness at a position more separated from the interface than the second position lower than the nanoindentation hardness at the second position.

Item 5. The semiconductor device substrate according to any one of Items 1 to 4, in which
each of the copper plate has a nanoindentation hardness at a third position separated from the interface by 100 µm in the thickness direction of 0.5 GPa to 1.1 GPa, and
each of the copper plate has a nanoindentation hardness at a position more separated from the interface than the third position lower than the nanoindentation hardness at the third position.

### Advantageous Effects of Invention

The semiconductor device substrate of the present invention can obtain a bonded substrate having high hot-cold cycle durability, in which peeling of a copper plate due to a temperature change can be suppressed.

### Brief Description of Drawings

[Fig. 1] Fig. 1 is a sectional view showing an embodiment of a semiconductor device including a semiconductor device substrate according to the present invention.
[Fig. 2] Fig. 2 is a sectional view showing an interface between a copper plate and a bonding layer.
[Fig. 3] Fig. 3 is a flowchart showing a method for producing a semiconductor device substrate.
[Fig. 4] Fig. 4 is a sectional view showing a production step of the semiconductor device substrate.
[Fig. 5] Fig. 5 is a sectional view showing a production step of the semiconductor device substrate.
[Fig. 6] Fig. 6 is a sectional view showing a production step of the semiconductor device substrate.
[Fig. 7] Fig. 7 is a temperature profile in a production step of the semiconductor device substrate.
[Fig. 8] Fig. 8 is a graph showing a schematic tendency showing a relationship between stress when a force acts in a direction of peeling off a plate from a bonding layer and a distance in a planar direction from an end of a circuit pattern.
[Fig. 9] Fig. 9 is a sectional view describing the horizontal axis of Fig. 8. Description of Embodiments

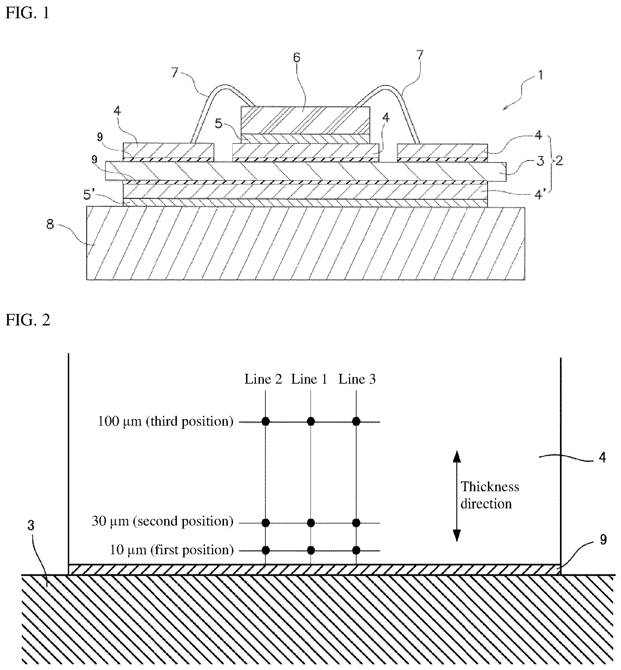

Hereinafter, an embodiment of a semiconductor device substrate according to the present invention will be described with reference to the drawings. Fig. 1 is a sectional view showing an example of a semiconductor device including a semiconductor device substrate according to the present embodiment.

### <1. Outline of Semiconductor Device>

The semiconductor device according to the present embodiment is used as a power module in various electronic devices such as a smartphone, a personal computer, a large white goods, a railway, an electric vehicle, power generation (wind power generation, solar power generation, fuel cell, etc.), an air conditioner, an industrial robot, a business elevator, a household microwave oven, an IH electric rice cooker, and a UPS (uninterruptible power supply).

As shown in Fig. 1, a semiconductor device 1 according to the present embodiment includes a semiconductor device substrate 2, a first bonding material 5, a second bonding material 5', a semiconductor chip 6, a bonding wire 7, and a heat sink 8.

The semiconductor device substrate 2 includes a plate-like ceramic substrate 3 that is an insulator, a first copper plate 4 bonded to an upper surface (first surface) of the ceramic substrate 3 via a bonding layer 9, and a second copper plate 4' bonded to a lower surface (second surface) of the ceramic substrate 3 via the bonding layer 9. As the ceramic substrate 3, for example, an aluminum oxide substrate, an aluminum nitride substrate, or silicon nitride can be used.

The bonding layer 9 can contain an active metal. The active metal may be, for example, at least one active metal selected from the group consisting of titanium and zirconium. Alternatively, the bonding layer 9 may contain a metal other than the active metal. The metal other than the active metal contained in the bonding layer 9 is, for example, at least one metal selected from the group consisting of silver, copper, indium, and tin. The bonding layer 9 may contain nitrogen and/or silicon supplied from the ceramic substrate 3, and the supplied nitrogen and/or silicon may form a compound with the active metal. A bonding layer 13 may contain copper supplied from a copper plate 12.

The first copper plate 4 is patterned to form a transmission circuit. On the other hand, the second copper plate 4' is formed in a flat plate shape.

The semiconductor chip 6 is bonded to the upper surface of the semiconductor device substrate 2, that is, a part of the upper surface of the first copper plate 4 via the first bonding material 5. The semiconductor chip 6 and the first copper plate 4 are connected by the bonding wire 7.

The heat sink 8 is bonded to the lower surface of the semiconductor device substrate 2, that is, the lower surface of the second copper plate 4' via the second bonding material 5. The heat sink 8 is a known heat sink, and can be made of metal such as copper, for example.

The thicknesses of the ceramic substrate 3, the copper plates 4 and 4', and the bonding layer 9 are not particularly limited, but for example, the thickness of the ceramic substrate is preferably 0.2 to 0.65 mm. The thickness of the copper plate is 0.3 mm or more, preferably 0.5 mm or more, still more preferably 0.8 mm or more. When the thickness of the copper plate is large, heat dissipation improves. The upper limit of the thickness of the copper plate is not particularly limited, but it may be, for example, 2.0 mm or less. The thickness of the bonding layer is preferably 0.1 to 20 µm.

### <2. Characteristics of Semiconductor Device Substrate>

As shown in Fig. 2, the semiconductor device substrate 2 according to the present embodiment is characterized in that the hardness decreases along the thickness direction of each of the copper plates 4 and 4' in a range between an interface between the bonding layer 9 and each of the copper plates 4 and 4' and a position separated from the interface by at least 100 µm. A specific hardness profile is not particularly limited, but is preferably configured as follows, for example.
(1) In the copper plates 4 and 4', the nanoindentation hardness at a first position separated from the interface with the bonding layer 9 by 10 µm in the thickness direction is 1.2 GPa to 2.3 GPa.
(2) In the copper plates 4 and 4', the nanoindentation hardness at a second position separated from the interface with the bonding layer 9 by 30 µm in the thickness direction is 0.7 GPa to 1.3 GPa.
(3) In the copper plates 4 and 4', the nanoindentation hardness at a third position separated from the interface with the bonding layer 9 by 100 µm in the thickness direction is 0.5 GPa to 1.1 GPa.

The above-described (1) to (3) are examples, but it is preferable to satisfy (1), it is more preferable to satisfy (1) and (2), and it is preferable to satisfy all of (1) to (3). In the present embodiment, the hardness of the region at least up to 100 µm (third position) from the interface decreases as the distance from the interface increases, but for example, when the above-described (1) is satisfied, the nanoindentation hardness at the third position side with respect to the first position may be lower than the nanoindentation hardness at the first position. That is, the nanoindentation hardnesses at the second position and the third position are not necessarily the nanoindentation hardnesses shown in (2) and (3). When the above-described (1) and (2) are satisfied, it is sufficient that the nanoindentation hardness at the third position side with respect to the second position is lower than the nanoindentation hardness at the second position. That is, the nanoindentation hardness at the third position is not necessarily the nanoindentation hardness shown in (3).

The nanoindentation hardness can be measured as follows. First, a region where a length of 10 mm or more can be secured is selected on the surfaces of the copper plates 4 and 4' of the semiconductor device substrate 2. That is, a region on the copper plates 4 and 4' that is not divided by patterning and in which a length of 10 mm or more can be secured is selected. Next, a length of 10 mm is selected, and the semiconductor device substrate 2 is cut so that the section including the midpoint of the length is exposed. Subsequently, the cut surface is polished by ion milling.

Next, as shown in Fig. 2, three lines sandwiching the midpoint are determined in the section after polishing. The first line is a line that passes through the midpoint and extends perpendicularly from the interface in the thickness direction. The second line is a line separated from the first line by 30 µm. The third line is a line separated from the first line by 30 µm on the opposite side from the second line.

Subsequently, the nanoindentation hardness is measured with a nanoindenter at the first position separated from the interface by 10 µm, the second position separated from the interface by 30 µm, and the third position separated from the interface by 100 µm on each line. Then, the nanoindentation hardnesses measured at the first positions, the second positions, and the third positions for the lines are averaged, and the averaged values are taken as the nanoindentation hardness at the first position, the second position, and the third position.

The above measurement method and measurement results can be applied to either a semiconductor device substrate in which the copper plates 4 and 4' are patterned as shown in Fig. 1, or a semiconductor device substrate in which patterning is not performed.

### <3. Method for Producing Semiconductor Device Substrate>

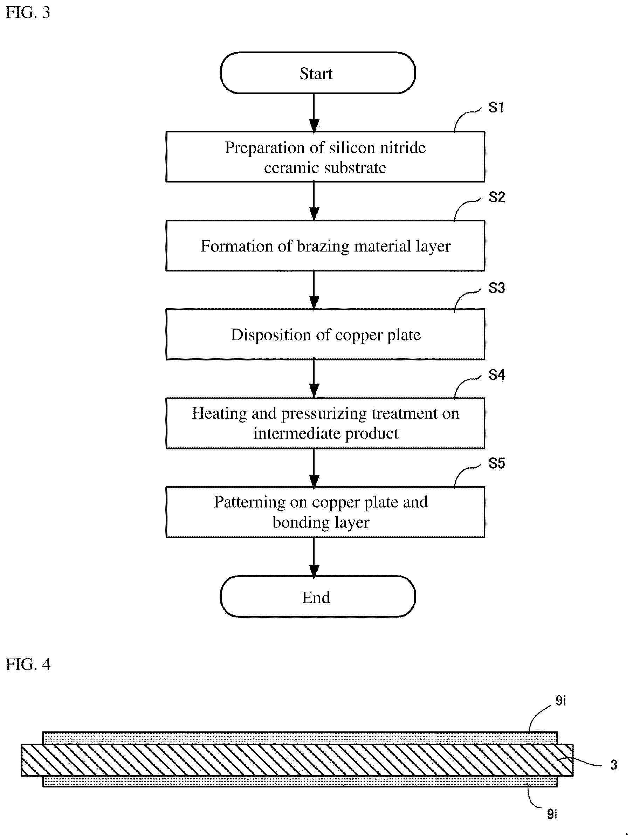

Next, a method for producing a semiconductor device substrate will be described. Fig. 3 is a flowchart showing a method for producing the semiconductor device substrate according to the present embodiment. Figs. 4, 5, and 6 are sectional views schematically showing an intermediate product obtained in the course of producing the semiconductor device substrate.

First, the ceramic substrate 3 is prepared (step S1). Next, as shown in Fig. 4, a brazing material layer 9i is formed on the upper surface and the lower surface of the ceramic substrate 3 (step S2). At this point, a paste containing an active metal brazing material, a binder, and a solvent is prepared as the brazing material layer 9i. The paste may further contain a dispersant, an antifoaming agent, and the like. Subsequently, the prepared paste is screen-printed on the upper surface and the lower surface of the ceramic substrate 3. A screen-printed film is thus formed on each surface of the ceramic substrate 3. Subsequently, the solvent contained in the formed screen-printed film is volatilized. This causes the screen-printed film to change to the brazing material layer 9i. The brazing material layer 9i contains the active metal brazing material and the binder. However, the brazing material layer 9i may be formed by a method different from this method.

The active metal brazing material contains a hydrogenated active metal powder and a metal powder. The hydrogenated active metal powder includes a hydrogenated product of at least one active metal selected from the group consisting of titanium and zirconium. The metal powder includes silver. The metal powder may include metal other than silver. The metal other than silver is at least one metal selected from the group consisting of copper, indium, and tin. When the active metal brazing material contains at least one metal selected from the group consisting of copper, indium, and tin, the melting point of the active metal brazing material decreases.

The active metal brazing material is desirably made of powder having an average particle diameter of 0.1 µm or more and 20 µm or less. The average particle diameter can be obtained by measuring a particle size distribution with a commercially available laser diffraction type particle size distribution measuring apparatus, and calculating D50 (median diameter) from the measured particle size distribution. When the active metal brazing material is made of powder having such a small average particle diameter, the brazing material layer 9i can be thinned.

The brazing material layer 9i desirably has a thickness of 0.1 µm or more and 20 µm or less, and more desirably has a thickness of 0.1 µm or more and 5 µm or less.

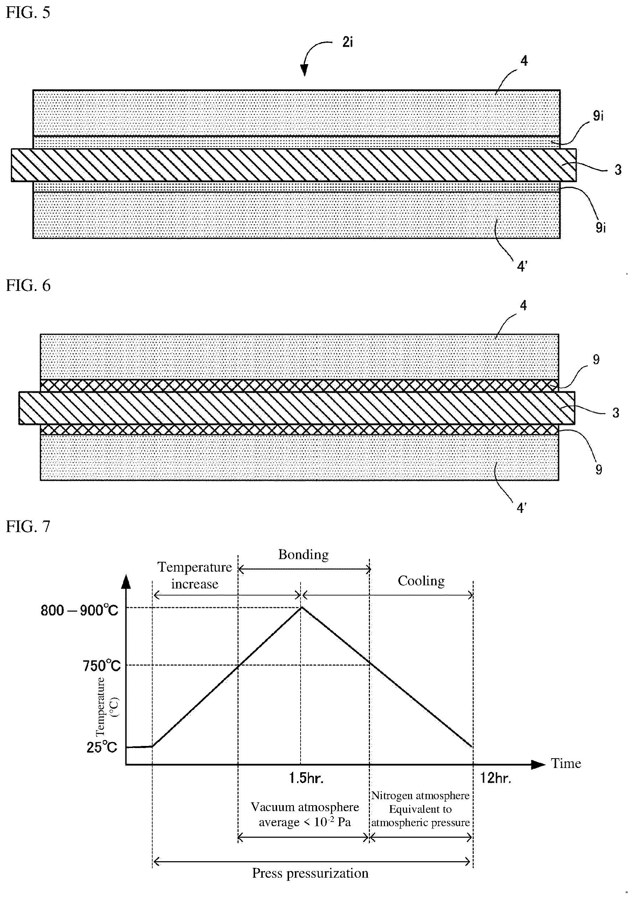

Next, as shown in Fig. 5, the copper plates 4 and 4' are disposed on the formed brazing material layer 9i (step S3). An intermediate product 2i including the ceramic substrate 3, the copper plates 4 and 4', and the brazing material layer 9i is thus obtained.

Subsequently, the obtained intermediate product 2i is subjected to a heating and pressurizing treatment (step S4). The bonding layer 9 is thus generated as illustrated in Fig. 6. As a result, the semiconductor device substrate 2 including the ceramic substrate 3, the copper plates 4 and 4', and the bonding layer 9 illustrated in Fig. 6 is obtained. The copper plates 4 and 4' are bonded to the ceramic substrate 3 by the bonding layer 9.

When the heating and pressurizing treatment is performed on the intermediate product 2i, heating is performed according to the temperature profile as illustrated in Fig. 7. As shown in Fig. 7, the inside of the furnace is heated so that the temperature of the intermediate product 2i becomes 800 to 900°C at a maximum under a vacuum atmosphere. The rate of temperature increase at this time can be, for example, 2 to 10 °C/min. In this process, the vacuum atmosphere in the furnace is adjusted to 10⁻² Pa or less in a time region from the temperature reaches the bonding layer forming temperature region of approximately 750°C or more to nitrogen substitution. The intermediate product 2i is pressurized during the temperature increasing process and until the cooling completion. At this time, the surface pressure applied to the intermediate product 2i can be adjusted to, for example, 0.2 Pa to 22 MPa. The ceramic, the bonding layer, and the copper plate are reliably brought into contact with each other through pressurization, they can react with each other, and thus the bonding layer can be formed.

Next, the state in which the temperature of the intermediate product 2i is 800 to 900°C is maintained for 30 to 60 minutes, and then the intermediate product 2i is cooled. Subsequently, when the temperature of the intermediate product reaches 650 to 800°C, an inert gas such as nitrogen is injected into the furnace, and the temperature is lowered in an inert gas atmosphere. The pressure at this time is preferably equal to or higher than the atmospheric pressure. The bonding layer 9 is formed in a vacuum atmosphere.

In the process of cooling the intermediate product 2i, rapid cooling is performed from 800 to 900°C to 200 to 300°C at approximately 2.8 to 12 °C/min. After the rapid cooling, slow cooling is performed to room temperature.

Next, the copper plate 4 and the bonding layer 9 are patterned by an etching method or the like (step S5). The copper plate 4 thus changes to a patterned copper plate 4 illustrated in Fig. 1. The bonding layer 9 also changes to a patterned bonding layer 13 illustrated in Fig. 1.

### <4. Features>

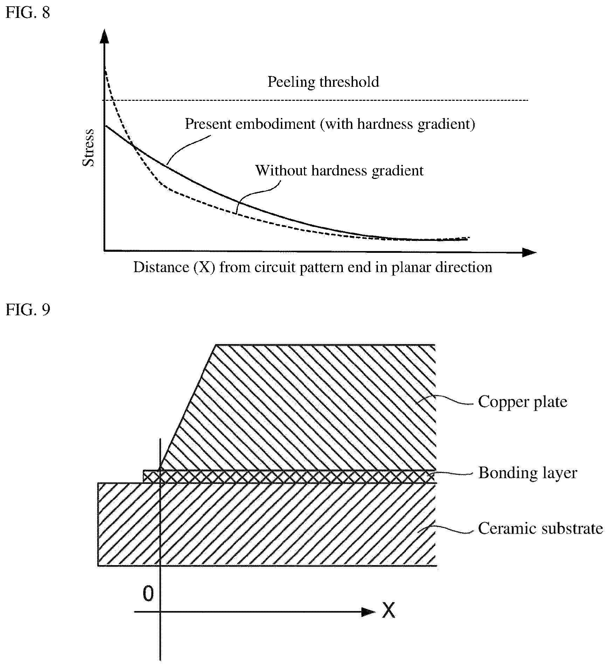

As described above, in the present embodiment, the hardness decreases along the thickness direction of the copper plates 4 and 4' in a range between the interface between the bonding layer 9 and each of the copper plates 4 and 4' and a position separated from the interface by at least 100 µm. That is, in the vicinity of the interface between the bonding layer 9 and each of the copper plates 4 and 4', the hardness decreases as the distance from the interface increases in the thickness direction, and thus peeling of the copper plates 4 and 4' can be suppressed. This point will be described with reference to Figs. 8 and 9.

Fig. 8 shows a stress distribution generated at the bonding interface during a hot-cold cycle treatment. Fig. 9 is a diagram describing the horizontal axis of Fig. 8. During the hot-cold cycle, a high stress is generated at the bonding interface because of a difference in thermal expansion between the copper 4 and 4 'and the ceramic substrate 3. As shown in Fig. 8, when the copper plates 4 and 4' have a gradient that decreases the hardness of copper, the force is dispersed, and the peak value of the stress generated at the interface decreases. Thus, the peak value of the stress in the vicinity of the end edges of the copper plates 4 and 4' (in particular, a region close to X = 0 in Figs. 8 and 9) is lower than the threshold value at which the peeling occurs, and it is possible to suppress the peeling of the end edges of the copper plates 4 and 4'.

When the thickness of the copper plates 4 and 4' is large, the heat dissipation is improved, but the possibility that the copper plates 4 and 4' are peeled off under the hot-cold cycle increases. However, in the present embodiment, since the copper plates 4 and 4 have the hardness gradient as described above, even when the thickness of the copper plates 4 and 4' is increased, peeling due to the hot-cold cycle can be effectively suppressed.

### Examples

Hereinafter, Examples of the present invention will be described. The present invention is not limited to the following Examples.

### <1. Production of Semiconductor Device Substrate>

A silicon nitride ceramic substrate having a thickness of 0.32 mm and a copper plate having a thickness of 0.8 mm were prepared. A brazing material containing an active metal brazing material containing 40 wt% or more and 95 wt% or less of silver and titanium hydride, the brazing material having a thickness of 0.1 µm or more and 20 µm or less, was also prepared. Then, this brazing material was applied to the upper and lower surfaces of the silicon nitride ceramic substrate by screen printing, and a copper plate was disposed thereon to form an intermediate product.

This intermediate product was then placed in a furnace and heated according to the temperature profile shown in Fig. 7. In the temperature increasing step, the temperature was increased to about 850°C at about 5 °C/min, and a pressure was applied at about 20 MPa when the temperature exceeded 750°C. Thereafter, cooling was performed at a cooling rate shown in Tables 2 to 5, and when the temperature was lowered to about 250°C, slow cooling was performed to normal temperature. Semiconductor device substrates according to Examples 1 to 9 and Comparative Example 1 were thus completed. That is, in Examples, three semiconductor device substrates were produced at one cooling rate. In these semiconductor substrates, the copper plate is not patterned.

### <2. Evaluation>

For the semiconductor device substrates according to Examples 1 to 9 and Comparative Example 1, the nanoindentation hardness at the first to third positions described above was measured. The measurement conditions are as shown in Table 1, and the results are as shown in Table 2.

**[Table 1]**

| Measurement conditions | |
|---|---|
| Measuring apparatus | Nano Indenter G200 manufactured by MTS Systems Corporation |
| Analysis software | Test Works 4 manufactured by MTS Systems Corporation |
| Indenter | Berkovich type made of diamond |
| Indentation depth (nm) | 300 |

**[Table 2]**

| Position | Cooling rate 2.8°C/min | | |
|---|---|---|---|
| | Example 1 | Example 2 | Example 3 |
| 3 | 0.50 | 0.60 | 0.62 |
| 2 | 0.70 | 0.81 | 0.90 |
| 1 | 1.20 | 1.44 | 1.50 |

**[Table 3]**

| Position | Cooling rate 6°C/min | | |
|---|---|---|---|
| | Example 4 | Example 5 | Example 6 |
| 3 | 0.80 | 0.86 | 0.96 |
| 2 | 1.03 | 1.10 | 1.18 |
| 1 | 1.89 | 1.90 | 2.00 |

**[Table 4]**

| Position | Cooling rate 12°C/min | | |
|---|---|---|---|
| | Example 7 | Example 8 | Example 9 |
| 3 | 0.70 | 0.88 | 1.10 |
| 2 | 1.00 | 1.20 | 1.30 |
| 1 | 1.80 | 1.95 | 2.30 |

**[Table 5]**

| Position | Cooling rate 1°C/min | | |
|---|---|---|---|
| | Comparative Example 1 | | |
| 3 | 1.2 | | |
| 2 | 1.2 | | |
| 1 | 1.2 | | |

Subsequently, the semiconductor device substrates according to Examples 1 to 9 and Comparative Example 1 were subjected to a hot-cold cycle test. That is, 3000 cycles of temperature increase and temperature decrease were repeated between -40°C and 175°C, then an ultrasonic flaw detection test was performed, and peeling of an end portion of the copper plate was checked. In the ultrasonic flaw detection test, an inspection was performed by a reflection method using an ultrasonic flaw detector FSesIII manufactured by Hitachi Power Solutions Co., Ltd. The results are as follows, and those in which peeling could not be confirmed were evaluated as OK, and those in which peeling could not be confirmed were evaluated as NO. In the image obtained by the ultrasonic flaw detection test, a gap is generated between the copper plate and the bonding layer at the place where the peeling has occurred, and the gap appears white. Thus, the peeling can be confirmed.

**[Table 6]**

| | Results of hot-cold cycle test |
|---|---|
| Example 1 | OK |
| Example 2 | OK |
| Example 3 | OK |
| Example 4 | OK |
| Example 5 | OK |
| Example 6 | OK |
| Example 7 | OK |
| Example 8 | OK |
| Example 9 | OK |
| Comparative Example 1 | NG |

From the results in Table 6, it was confirmed that the copper plate having a hardness gradient in which the nanoindentation hardness decreases from the first position to the third position was not peeled off in the hot-cold cycle test. On the other hand, in Comparative Example 1 having no such hardness gradient, the copper plate was peeled off. Thus, it has been found that when the copper plate has the hardness gradient as described above, peeling of the copper plate can be suppressed.

### Reference Signs List

2 Semiconductor device substrate
3 Ceramic substrate
4, 4' Copper plate
9 Bonding layer

## Claims

1. A semiconductor device substrate comprising:
a ceramic substrate having a first surface and a second surface;
bonding layers respectively disposed on the first surface and the second surface; and
copper plates respectively disposed on the bonding layers,
wherein each of the copper plates has a thickness of 0.3 mm or more, and
each of the copper plates includes a region where hardness decreases along a thickness direction of the copper plate between a position separated from an interface between a corresponding one of the bonding layers and the copper plate by 100 µm in the thickness direction and the interface.

2. The semiconductor device substrate according to claim 1, wherein at least one of the copper plates is patterned.

3. The semiconductor device substrate according to claim 1 or 2, wherein
each of the copper plate has a nanoindentation hardness at a first position separated from the interface by 10 µm in the thickness direction of 1.2 GPa to 2.3 GPa, and
each of the copper plate has a nanoindentation hardness at a position more separated from the interface than the first position lower than the nanoindentation hardness at the first position.

4. The semiconductor device substrate according to claim 3, wherein
each of the copper plate has a nanoindentation hardness at a second position separated from the interface by 30 µm in the thickness direction of 0.7 GPa to 1.3 GPa, and
each of the copper plate has a nanoindentation hardness at a position more separated from the interface than the second position lower than the nanoindentation hardness at the second position.

5. The semiconductor device substrate according to claim 4, wherein
each of the copper plate has a nanoindentation hardness at a third position separated from the interface by 100 µm in the thickness direction of 0.5 GPa to 1.1 GPa, and
each of the copper plate has a nanoindentation hardness at a position more separated from the interface than the third position lower than the nanoindentation hardness at the third position.
